# EUROPÄISCHE PATENTSCHRIFT

(11) **EP 3 000 791 B1**
(45) Veröffentlichungstag und Bekanntmachung des Hinweises auf die Patenterteilung: **26.04.2017**
(21) Anmeldenummer: 14186139.3
(22) Anmeldetag: 24.09.2014
(51) Int. Cl.: C03C 3/06, C03B 19/14

(54) **Verfahren zur Herstellung eines Rohlings aus Fluor- und Titan-dotiertem, hochkieselsäurehaltigem Glas für den Einsatz in der EUV-Lithographie und danach hergestellter Rohling**
Method for manufacturing a blank made of fluoride and titanium doped, highly-silicate glass for use in EUV lithography and blank manufactured according to said method
Procédé de fabrication d'une ébauche en verre contenant de l'acide silicique à haute densité, du fluor et doté de titane pour l'utilisation dans la lithographie EUV et ébauche ainsi obtenue

(43) Veröffentlichungstag der Anmeldung: 30.03.2016
(73) Patentinhaber: Heraeus Quarzglas GmbH & Co. KG, 63450 Hanau (DE)
(72) Erfinder: Ochs, Stefan, 63571 Gelnhausen (DE); Becker, Klaus, 63452 Hanau (DE)
(74) Vertreter: Staudt, Armin Walter

(56) Entgegenhaltungen:
- EP-A1- 2 371 773
- EP-A1- 2 377 826
- EP-A1- 2 428 488
- WO-A1-2006/004169
- WO-A1-2009/084717
- WO-A1-2009/116690
- WO-A2-2011/078414
- DE-A1-102013 002 802
- DE-B3-102013 108 885
- US-A1- 2010 179 047
- US-A1- 2014 155 246
- SAITO K ET AL: "Effects of fluorine on structure, structural relaxation, and absorption edge in silica glass", JOURNAL OF APPLIED PHYSICS, AMERICAN INSTITUTE OF PHYSICS, US, Bd. 91, Nr. 8, 15. April 2002 (2002-04-15) , Seiten 4886-4890, XP012056198, ISSN: 0021-8979, DOI: 10.1063/1.1459102

## Beschreibung

### Technischer Hintergrund

Die vorliegende Erfindung betrifft ein Verfahren zur Herstellung eines Rohlings aus Titan-dotiertem, hochkieselsäurehaltigem Glas mit einer internen Transmission von mindestens 60 % im Wellenlängenbereich von 400 nm bis 700 nm bei einer Probendicke von 10 mm und mit einem vorgegebenen Fluorgehalt für den Einsatz in der EUV-Lithographie.

Weiterhin betrifft die Erfindung einen Rohling aus Titan-dotiertem Kieselglas für den Einsatz in der EUV-Lithographie.

### Stand der Technik

Bei der EUV Lithographie werden mittels mikrolithographischer Projektionsgeräte hochintegrierte Strukturen mit einer Linienbreite von weniger als 50 nm erzeugt. Dabei wird Strahlung aus dem EUV-Bereich (Extrem ultraviolettes Licht, auch weiche Röntgenstrahlung genannt) mit Wellenlängen um 13 nm eingesetzt. Die Projektionsgeräte sind mit Spiegelelementen ausgestattet, die aus hochkieselsäurehaltigem und mit Titandioxid dotiertem Glas (im Folgenden auch als "TiO₂-SiO₂-Glas" oder als "Ti-dotiertes Kieselglas" bezeichnet) bestehen und die mit einem reflektierenden Schichtsystem versehen sind. Diese Werkstoffe zeichnen sich durch einen extrem niedrigen linearen thermischen Ausdehnungskoeffizienten (kurz als "CTE" bezeichnet; coefficient of thermal expansion) aus, der durch die Konzentration an Titan einstellbar ist. Übliche Titandioxid-Konzentrationen liegen zwischen 6 und 9 Gew.-%.

Beim bestimmungsgemäßen Einsatz derartiger Rohlinge aus synthetischem, titandotiertem hochkieselsäurehaltigem Glas als Spiegelsubstrat ist dessen Oberseite verspiegelt. Die maximale (theoretische) Reflektivität eines derartigen EUV-Spiegelelements liegt bei etwa 70%, so dass mindestens 30% der Strahlungsenergie in der Beschichtung oder in der oberflächennahen Schicht des Spiegelsubstrats absorbiert und in Wärme umgesetzt werden. Dies führt im Volumen des Spiegelsubstrats zu einer inhomogenen Temperaturverteilung mit Temperaturdifferenzen, die laut Literaturangaben bis zu 50°C betragen können.

Für eine möglichst geringe Deformation wäre es daher wünschenswert, wenn das Glas des Spiegelsubstrat-Rohlings einen CTE hätte, der über den gesamten Temperaturbereich der im Einsatz auftretenden Arbeitstemperaturen bei Null läge. Tatsächlich kann bei Ti-dotierten Kieselgläsern der Temperaturbereich mit einem CTE um Null jedoch sehr eng sein.

Diejenige Temperatur, bei der der thermische Ausdehnungskoeffizient des Glases gleich Null ist, wird im Folgenden auch als Nulldurchgangs-Temperatur oder als T_{ZC} (Temperature of Zero Crossing) bezeichnet. Die Titan-Konzentration ist in der Regel so eingestellt, dass sich ein CTE von Null im Temperaturbereich zwischen 20 °C und 45 °C ergibt. Volumenbereiche des Spiegelsubstrats mit höherer oder niedrigerer Temperatur als der voreingestellten T_{ZC} dehnen sich oder ziehen sich zusammen, so dass es trotz insgesamt niedrigem CTE des TiO₂-SiO₂-Glases zu Verformungen kommt, unter denen die Abbildungsqualität des Spiegels leidet.

Zusätzlich spielt die fiktive Temperatur des Glases eine Rolle. Die fiktive Temperatur ist eine Glas-Eigenschaft, die den Ordnungszustand des "eingefrorenen" Glasnetzwerkes repräsentiert. Eine höhere fiktive Temperatur des TiO₂-SiO₂-Glases geht mit einem geringeren Ordnungszustand der Glasstruktur und einer größeren Abweichung von der energetisch günstigsten strukturellen Anordnung einher.

Die fiktive Temperatur wird von der thermischen Vorgeschichte des Glases geprägt, insbesondere vom letzten Abkühlprozess. Beim letzten Abkühlprozess ergeben sich für oberflächennahe Bereiche eines Glasblocks zwangsläufig andere Bedingungen als für zentrale Bereiche, so dass unterschiedliche Volumenbereiche des Spiegelsubstrat-Rohlings bereits aufgrund ihrer unterschiedlichen thermischen Historie unterschiedliche fiktive Temperaturen haben, die wiederum mit entsprechend inhomogenen Bereichen hinsichtlich des Verlaufs des CTE korrelieren. Zusätzlich wird die fiktive Temperatur aber auch durch den Anteil an Fluor beeinflusst, da Fluor sich auf die Strukturrelaxation auswirkt. Eine Fluordotierung ermöglicht die Einstellung einer niedrigeren fiktiven Temperatur und in der Konsequenz auch eine geringere Steigung des CTE-Verlaufs über der Temperatur.

Das Ti-dotierte Kieselglas wird durch Flammenhydrolyse ausgehend von Silizium und Titan enthaltenden Precursor-Substanzen hergestellt. Zunächst wird ein poröser Sootkörper aus mit Titan dotiertem SiO₂ erzeugt, der zu einem dichten Glaskörper verglast wird. Gegebenenfalls wird der Sootkörper vor dem Verglasen einer Trocknung unterzogen, beispielsweise durch eine Behandlung in Halogenhaltiger Atmosphäre, zur Reduzierung des Hydroxylgruppengehalts (OH-Gruppengehalt). Die Dotierung mit Titanoxid führt jedoch aufgrund einer mehr oder weniger starken Konzentration von Ti³⁺ Ionen in der Glasmatrix zu einer bräunlichen Färbung des Glases. Die Formkörper für diese Anwendung, im Folgenden auch Rohlinge oder Blanks genannt, sind große, dunkelbraune Platten mit Abmessungen bis zu etwa 70 x 60 x 20 cm³, die hinsichtlich ihrer optischen Eigenschaften bzw. auf herstellungsbedingte Defekte oder Inhomogenität überprüft werden müssen. Die bräunliche Färbung des Glases hat sich dabei als problematisch erwiesen, weil dadurch übliche optische Messverfahren, die Transparenz im sichtbaren Spektralbereich voraussetzen, nur eingeschränkt oder gar nicht anwendbar sind.

In der Literatur sind verschiedene Lösungsvorschläge gemacht worden, den Anteil der Ti³⁺ Ionen zugunsten von Ti⁴⁺ Ionen durch eine Oxidationsbehandlung zu begrenzen. Wird ein Ti-dotiertes Kieselglas mit relativ hohem Hydroxylgruppengehalt eingesetzt, ermöglichen die OH-Gruppen die gewünschte Oxidation von Ti³⁺ in Ti⁴⁺. So beschreiben es Carson u. Mauer für Ti-dotiertes Kieselglas in "Optical Attenuation In Titania-Silica Glasses", J. Non-Crystalline Solids, Vol. 11 (1973), S. 368-380, wobei eine Reaktion gemäß der Formel 2Ti³⁺ + 20H⁻ → 2Ti⁴⁺ +2O²⁻ + H₂ angegeben wird.

Diese Vorgehensweise wird in EP 2 428 488 A1 aufgegriffen, insbesondere hinsichtlich optimierter Bedingungen für den Prozess des Oxidierens und Ausdiffundierens des Wasserstoffs während einer Temperbehandlung. Das in EP 2 428 488 A1 offenbarte Ti-dotierte Kieselglas ist nicht mit Fluor dotiert, hat einen hohen OH-Gehalt von mehr als 600 Gew.-ppm und einen relativ niedrigen Wasserstoffgehalt (kleiner 2 x 10¹⁷ Moleküle/cm³). Um einen hohen OH-Gehalt zu gewährleisten, wird eine Wasserdampfzugabe während des Abscheideprozesses empfohlen, wobei sowohl ein zweistufiger Abscheideprozess, bei dem zunächst TiO₂-SiO₂-Sootpartikel anfallen, die anschließend konsolidiert und verglast werden, als auch ein einstufiger Prozess beschrieben wird, bei dem die Sootpartikel sofort verglast werden (sogenanntes "direct quartz" oder "DQ-Verfahren"). Der Anteil der Ti³⁺ Ionen im Ti-dotierten Kieselglas wird mit kleiner 3 ppm angegeben, die interne Transmission über einen Wellenlängenbereich von 340 nm bis 840 nm liegt bei größer 90 %, wobei allerdings keine Angaben zur Probendicke gemacht werden.

Aus WO 2004/089836 A1 ist ein Ti-dotiertes Kieselglas mit einer Fluor-Dotierung bekannt, das einen sehr flachen Verlauf des Wärmeausdehnungskoeffizienten über einen relativ breiten Temperaturbereich aufweist. Zunächst wird der poröse TiO₂-SiO₂-Sootkörper bei 1200°C in Luft vorgetrocknet, was eine erste Reduzierung des OH-Gehaltes und eine Oxidierung von Ti³⁺ Ionen zur Folge hat. Anschließend wird der TiO₂-SiO₂-Sootkörper zur Fluor-Dotierung für mehrere Stunden einer Atmosphäre mit 10 Vol.-% SiF₄ in Sauerstoff oder in Helium ausgesetzt. Diese Behandlung hat neben der Fluor-Dotierung außerdem eine weitere Reduzierung des OH-Gehaltes zur Folge. Um eine Dunkelfärbung während der Verglasung des Sootkörpers zu verhindern, wird gemäß WO 2004/089836 A1 vorgeschlagen, den Sootkörper vor dem Verglasen in einer Sauerstoffatmosphäre für mehrere Stunden im Temperaturbereich zwischen 300°C und 1300°C zu behandeln, bevor sich der Verglasungsschritt unter Helium anschließt. Der Glaskörper aus Fluor- und Titan-dotiertem Kieselglas wird danach zu einem Rohling umgeformt und zwecks Einstellung der fiktiven Temperatur einer Temperbehandlungen unterzogen. Angaben zum Anteil an Ti³⁺ Ionen oder zur Dunkelfärbung bzw. zur internen Transmission finden sich in WO 2004/089836 A1 nicht.

In WO2006/004169 A1 werden die Beispiele aus WO2004/089836 A1 hinsichtlich des Anteils an Ti³⁺ und Angaben zur internen Transmission fortgeführt. In dem Verfahren nach WO2006/004169 A1 ist ebenfalls eine Sauerstoff-Behandlung eines TiO₂-SiO₂-Sootkörpers mit Fluor-Dotierung vor dem Verglasen (unter Helium) vorgesehen. Die Fluor-Dotierung wird in einer Sauerstoff und Fluor enthaltenden Atmosphäre durchgeführt. Das so hergestellte Ti-dotierte Kieselglas enthält 10 Gew.-ppm OH-Gruppen und 12 Gew.-ppm Ti³⁺ Ionen. Der Fluorgehalt liegt bei 120 bzw. 6300 Gew.-ppm. Die interne Transmission im Wellenlängenbereich von 400 nm bis 700 nm wird bei diesem relativ hohen Anteil an Ti³⁺ Ionen mit größer 80 % angegeben, - dies allerdings für eine Glasdicke von nur einem Millimeter. Umgerechnet auf eine 10 mm dicke Probe entspricht dies einem Wert für die interne Transmission von nur 10%.

Die Verfahren gemäß WO 2004/089836 A1 und WO2006/004169 A1 sind technisch sehr aufwändig und führen dabei nicht zu einer akzeptablen, ausreichend hohen internen Transmission für realistische Probendicken im Bereich von 10 mm.

Aus US 2006/0179879 A1 ist bekannt, dass bei einem TiO₂-SiO₂ Glas für den Einsatz in der EUV-Lithographie neben einer homogenen Verteilung der Titan-Konzentration der Verlauf des CTE über die sich im Betrieb einstellende Temperatur durch weitere Parameter, unter anderem durch eine Dotierung mit Fluor und durch den OH-Gehalt beeinflusst werden kann. Das Fluor dient auch als Trocknungsreagenz, mit dem der OH-Gehalt auf kleiner 100 ppm eingestellt werden kann. Umgekehrt wird durch Einwirkung von Wasserdampf während der Verglasung ein OH-Gehalt von bis zu 1500 ppm erreicht. In einer speziellen Ausführungsform gemäß US 2006/0179879 A1 wird mittels Flammenhydrolyse von Silizium, Titan und Fluor enthaltenden Ausgangssubstanzen ein fluordotierter TiO₂-SiO₂-Sootkörper erhalten. In einem darauf folgenden Prozessschritt wird der Sootkörper in einer Inertgas-Atmosphäre, die Wasserdampf enthält, verglast oder konsolidiert. Der Fluor-Gehalt dieses TiO₂-SiO₂ Glases liegt im Bereich von 500 bis 2000 Gew.-ppm. Zum Anteil der Ti³⁺ Ionen im TiO₂-SiO₂-Glas, zum OH-Gehalt und zur internen Transmission im sichtbaren Wellenlängenbereich dieses Fluordotiertem TiO₂-SiO₂-Glases werden keine Angaben gemacht.
Neben dem vorgenannten speziellen Beispiel wird in US 2006/0179879 A1 unter der Überschrift "Soot Formation Followed by Consolidation" auch allgemein auf die Herstellung von Quarzglas nach dem sogenannten Sootverfahren eingegangen.

Demnach kann der SiO₂-Sootkörper bei etwa 1000°C einer Behandlung mit Helium, Wasserstoff, Wasserdampf oder einem Dotiergas wie CF₄, im Fall einer gewünschten Fluor-Dotierung, unterzogen werden, bevor sich ein Verglasungsschritt bei höherer Temperatur anschließt. Zu den Auswirkungen der Behandlung mit Helium, Wasserstoff oder Wasserdampf auf den SiO₂-Sootkörper bzw. auf das gesinterte Quarzglas finden sich keine Angaben. Man muss jedoch davon ausgehen, dass, da offenbar keine Trocknung des Sootkörpers vor dem Verglasen vorgesehen ist, ein hoher OH-Gehalt im Sootkörper vorliegt, der sich durch die Wasserdampf enthaltene Atmosphäre noch erhöhen dürfte und beim Verglasen zu unerwünschten Blasen führen wird.

### Technische Aufgabenstellung

Zusammenfassend ist festzustellen, dass nach dem Stand der Technik die Verringerung von Ti³⁺ Ionen zugunsten von Ti⁴⁺ Ionen in Ti-dotiertem Kieselglas entweder durch einen ausreichend hohen Anteil an OH-Gruppen sicher gestellt wird, wodurch eine interne Oxidation mit Ausdiffusion von Wasserstoff erfolgt, oder bei niedrigem OH-Gruppenanteil eine Sauerstoffbehandlung vor dem Verglasen erforderlich ist, die eine hohe Behandlungstemperatur und spezielle korrosionsbeständige Öfen erfordert und dementsprechend kostspielig ist.

Bei TiO₂-SiO₂-Glas mit F-Codotierung ist die Problematik der Braunfärbung durch einen hohen Anteil von Ti³⁺ Ionen besonders ausgeprägt, da durch das Fluor praktisch keine OH-Gruppen mehr vorliegen, die eine Oxidation von Ti³⁺ in Ti⁴⁺ bewirken könnten.

Darüber hinaus hat sich herausgestellt, dass die bekannte Sauerstoffbehandlung vor dem Verglasen zwar den Anteil an Sauerstoff zuverlässig erhöht, wodurch die Oxidation zugunsten von Ti⁴⁺ Ionen einmalig stattfindet, diese Maßnahme jedoch nicht nachhaltig ist, wenn beispielsweise der verglaste Rohling unter reduzierender Atmosphäre, wie etwa durch Anwendung einer reduzierend eingestellten Knallgas-Flamme, umgeformt wird. Das heißt, der Sauerstoff steht durch die Sauerstoffbehandlung nur einmalig zur Oxidation von Ti³⁺ zu Ti⁴⁺ zur Verfügung, so dass unter reduzierenden Bedingungen es wieder zur vermehrten Bildung von Ti³⁺ Ionen kommt, was bekanntlich zur Dunkelfärbung des Glases führt.

Der Erfindung liegt daher die Aufgabe zugrunde, ein kostengünstiges Herstellungsverfahren für mit Titan und Fluor dotiertem hochkieselsäurehaltigen Glas anzugeben, das bei einem OH-Gehalt von weniger als 100 Gew.-ppm eine interne Transmission bei einer Probendicke von 10 mm von mindestens 60% im Wellenlängenbereich von 400 nm bis 700 nm zeigt, wobei die OH-Gruppen auch nach Einwirkung von reduzierender Atmosphäre auf das Glas eine verlängerte Wirkungsperiode im Sinne eines Depots für die interne Oxidation von Ti³⁺ Ionen in Ti⁴⁺ Ionen aufweisen.

Weiterhin liegt der Erfindung die Aufgabe zugrunde einen derartigen mit Titan und Fluor co-dotierten Kieselglas-Rohling bereitzustellen.

### Allgemeine Beschreibung der Erfindung

Hinsichtlich des Verfahrens wird diese Aufgabe ausgehend von dem Verfahren der eingangs genannten Gattung erfindungsgemäß mit den folgenden Verfahrensschritten gelöst:
(a) Herstellen eines TiO₂-SiO₂-Sootkörpers mittels Flammenhydrolyse von Silizium und Titan enthaltenden Ausgangssubstanzen,
(b) Fluorieren des Sootkörpers unter Bildung eines mit Fluor dotierten TiO₂-SiO₂-Sootkörpers,
(c) Behandeln des mit Fluor dotierten TiO₂-SiO₂-Sootkörpers in einer Wasserdampf enthaltenden Atmosphäre unter Bildung eines konditionierten Sootkörpers,
(d) Verglasen des konditionierten Sootkörpers unter Bildung eines Rohlings aus Titan-dotiertem, hochkieselsäurehaltigem Glas mit einem mittleren Hydroxylgruppengehalt im Bereich von 10 Gew.-ppm bis 100 Gew.-ppm und einem mittleren Fluorgehalt im Bereich von 2.500 Gew.-ppm bis 10.000 Gew.-ppm.

Bei der Herstellung von synthetischem, Ti-dotiertem Kieselglas nach dem so genannten "Sootverfahren" durch Flammenhydrolyse werden in der Flamme durch Hydrolyse oder Oxidation erzeugte SiO₂- und TiO₂-Partikel zunächst unter Bildung eines TiO₂-SiO₂-Sootkörpers auf einer Ablagerungsfläche abgeschieden (Verfahrensschritt (a)). Alternativ zum "Sootverfahren" gemäß der Erfindung kann Ti-dotiertes Kieselglas auch nach den einstufigen "Direktverfahren" hergestellt werden, bei dem die abgeschiedenen SiO₂- und TiO₂-Partikel direkt verglast werden, wobei sich typischerweise ein höherer OH-Gehalt im Bereich von etwa 450 bis 1200 Gew.-ppm einstellt. Das nach dem Direktverfahren hergestellte Ti-dotierte Kieselglas ist jedoch nicht Gegenstand der Erfindung.

In dem weiteren Verfahrensschritt (b) wird der Sootkörper mit Fluor dotiert, so dass ein Fluorgehalt im Bereich von 2500 Gew.-ppm bis 10 000 Gew.-ppm in dem verglasten Rohling eingestellt wird. Durch die Fluorierung werden die Hydroxylgruppen im Wesentlichen entfernt. Dieser Zustand hat den Nachteil, dass keine Hydroxylgruppen zur Oxidation von Ti³⁺ in Ti⁴⁺ zur Verfügung stehen und mit einer starken Braunfärbung des Rohlings aus fluordotiertem TiO₂-SiO₂-Glas gerechnet werden muss.

Zur nachhaltigen Vermeidung oder zumindest Reduzierung der Braunfärbung schließt sich an die Fluorierung des TiO₂-SiO₂-Sootkörpers mit Verfahrensschritt (c) eine Konditionierungsbehandlung in einer Wasserdampf enthaltenden Atmosphäre an, wodurch ein konditionierter Sootkörper mit für die Oxidation von Ti³⁺ zu Ti⁴⁺ ausreichenden Anteil an Hydroxylgruppen erhalten wird.

Der konditionierte Sootkörper wird anschließend unter Bildung eines Rohlings aus Titan-dotiertem, hochkieselsäurehaltigem Glas mit einem OH-Gehalt im Bereich von 10 Gew.-ppm bis 100 Gew.-ppm verglast (Verfahrensschritt (d)).

Der Kerngedanke des erfindungsgemäßen Verfahrens besteht darin im TiO₂-SiO₂-Sootkörper durch eine oxidative Konditionierungsbehandlung mit Wasserdampf die Konzentration von Ti³⁺ Ionen zugunsten von Ti⁴⁺ vor dem Verglasen zu reduzieren. Die Konditionierungsbehandlung mit Wasserdampf erfolgt vor dem Verglasungsschritt, da in diesem Stadium noch ein offenporiger Sootkörper vorliegt, in dem Hydroxylgruppen leicht eingebaut werden können. Der Einbau der Hydroxylgruppen erfolgt dabei so, dass sie hinsichtlich der internen Oxidation von Ti³⁺ zu Ti⁴⁺ eine Depotwirkung haben für nachfolgende Verfahrensschritte, die unter reduzierenden Bedingungen stattfinden. Es stellt sich bei der Konditionierungsbehandlung auch eine besonders homogene Verteilung der Hydroxylgruppen innerhalb des Sootkörpers ein. Die innerhalb der Glaspartikel eingebundenen Fluor-Liganden bleiben dabei im Wesentlichen erhalten, so dass mit dem erfindungsgemäßen Verfahren ein TiO₂-SiO₂-Rohling erhalten wird, der mit Fluor dotiert ist und gleichzeitig einen ausreichend hohen OH-Gehalt aufweist, um die Oxidation von Ti³⁺ zu Ti⁴⁺ zu gewährleisten.

Durch die Konditionierungsbehandlung werden OH-Gruppen als Depot in den Sootkörper eingebaut, so dass sie nicht nur einmalig für die interne Oxidation zur Verfügung stehen, sondern auch noch nach Anwendung reduzierender Bedingungen in nachfolgenden Verfahrensschritten Wirkung zeigen, im Sinne einer erneuten internen Oxidation während einer relativ kurzen, je nach Volumen des Rohlings einige Tage andauernde Temperaturbehandlung im Bereich zwischen 600°C und 1000°C, in der Regel an Luft oder in Vakuum, die wieder zu einem minimierten Anteil an Ti³⁺-Ionen führt.

Das nach dem erfindungsgemäßen Verfahren herzustellende Ti-dotierte Kieselglas enthält Titandioxid im Bereich von 6 Gew.-% bis 12 Gew.-%, was einem Titangehalt von 3,6 Gew.-% bis 7,2 Gew.-% entspricht. Im TiO₂-SiO₂-Sootkörper liegt das Titan zumindest teilweise in der Oxidationsform Ti³⁺ vor. Angestrebt wird, dass möglichst alle Ti³⁺ Ionen in Ti⁴⁺ Ionen überführt werden, so dass keine störende Absorption im Wellenlängenbereich von 400 nm bis 1000 nm aufgrund von Ti³⁺ Ionen zu beobachten ist und das Ti-dotierte Kieselglas demnach größtmögliche Transparenz in diesem Wellenlängenbereich zeigt. Dadurch, dass der Sootkörper aufgrund der Fluordotierung keine OH-Gruppen oder nur einen geringen Anteil (< 10 Gew.-ppm) an OH-Gruppen aufweist, können diese wenig zur Oxidation von Ti³⁺ nach Ti⁴⁺ beitragen. Als oxidatives Behandlungsreagenz wird erfindungsgemäß eine Konditionierungsbehandlung mit einer Wasserdampf enthaltenden Atmosphäre vor dem Verglasungsschritt durchgeführt. Der offenporige Sootkörper reagiert auch bei relativ niedriger Temperatur mit dem Wasserdampf, so dass Ti³⁺ Ionen zu Ti⁴⁺ Ionen umgesetzt werden. Die OH-Gruppen werden als Si-OH-Gruppen in das Glasnetzwerk eingebaut. Die OH-Gruppen stehen auch noch nach der Behandlung in reduzierender Atmosphäre bei nachfolgenden Verfahrensschritten wie etwa der Umformung in einem Graphitofen für die interne Oxidation von Ti³⁺ zu Ti⁴⁺ zur Verfügung.

Wird der Wasserdampf erst - wie nach dem Stand der Technik - während der Verglasung eingesetzt, ist seine Wirkung in Bezug auf die Reaktion der OH-Gruppen mit den Ti³⁺ Ionen eher gering und ungleichmäßig, da mit steigender Temperatur der Sootkörper versintert, so dass sich seine innere und äußere Oberfläche nach und nach verkleinert und dadurch ein Eindringen und Reagieren der OH-Gruppen aus dem Wasserdampf behindert wird. Es ist vielmehr zu erwarten, dass der Wasserdampf zur Blasenbildung im Glas führt, was für ein Verfahren zur Herstellung eines Rohlings aus Titan-dotiertem, hochkieselsäurehaltigem Glas nicht akzeptabel ist.

Im Vergleich zur Behandlung des TiO₂-SiO₂-Sootkörpers in einer Sauerstoffatmosphäre, wie dies aus dem Stand der Technik bekannt ist, ist beim erfindungsgemäßen Verfahren die Konditionierungsbehandlung mit Wasserdampf technisch und energetisch wenig aufwändig . Mit dem erfindungsgemäßen Verfahren ist es möglich die Konditionierungsbehandlung in Glas- oder Keramiköfen durchzuführen, die auch für das Trocknen und das Verglasen des Sootkörpers unter Vakuum oder/und unter Edelgas eingesetzt werden. Das erfindungsgemäße Verfahren ist damit besonders wirtschaftlich. Es ist überdies vorteilhaft einen OH-Gehalt zwischen 10 und 100 Gew.-ppm einzustellen, da dieser zu besonders hoher Homogenität des CTE und der fiktiven Temperatur führt. Bei einem OH-Gehalt größer 100 ppm ist nämlich die Verteilung der OH-Gruppen ungleichmäßiger und bei besonders hohem OH-Gehalt ist sogar mit Blasenbildung im Glas zu rechnen.

Auch gegenüber einer Konditionierungsbehandlung mit Stickoxiden, die ebenfalls zur gewünschten Oxidation von Ti³⁺ in Ti⁴⁺ führen, ist das erfindungsgemäße Verfahren unter Einsatz von Wasserdampf vorzuziehen, da die meisten Stickoxide giftig und wenig umweltfreundlich sind und überdies zum wirksamen Einsatz eine höhere Temperatur als Wasserdampf benötigen. Wasserdampf hat den besonderen Vorteil, dass er großtechnisch in hoher Reinheit erhältlich und ungefährlich ist.

Bei der Zersetzung von Wasserdampf entstehen reaktive OH-Gruppen, die bereits bei relativ niedriger Temperatur mit den Ti³⁺ Ionen reagieren. Die Reaktion der Ti³⁺ Ionen mit Wasserdampf erfolgt nach der folgenden Reaktionsgleichung (1) unter Freisetzung von Wasserstoff (H₂) :

(1) 2 Ti³⁺ + H₂O → 2 Ti⁴⁺ + O²⁻ + H₂

Die durch die Konditionierungsbehandlung mit Wasserdampf in das mit Fluor und Titan dotierte Kieselglas eingebrachten OH-Gruppen bewirken nicht nur einmalig eine interne Oxidation der Ti³⁺ Ionen zu Ti⁴⁺ , sondern stehen auch noch für eine erneute interne Oxidation zur Verfügung (Depotwirkung) wenn reduzierende Atmosphäre bei hoher Temperatur auf den verglasten Rohling einwirkt und sich dabei erneut Ti³⁺ Ionen bilden, die die interne Transmission des Rohlings verschlechtern.

Dementsprechend hat sich für diese Situation bewährt, wenn der Rohling nach dem Verglasen gemäß Verfahrensschritt (d) einer Behandlung in reduzierender Atmosphäre unterzogen wird, und sich dabei das Verhältnis Ti³⁺ / Ti⁴⁺ vergrößert unter Reduzierung der internen Transmission im Wellenlängenbereich 400 nm bis 700 nm, anschließend den Rohling einer Temperbehandlung bei einer Temperatur im Bereich zwischen 600°C und 1000°C zu unterziehen, um die Reduzierung der internen Transmission rückgängig zu machen. Eine Einwirkung von reduzierender Atmosphäre findet beispielsweise beim Umformen des Rohlings in einer Graphitform statt und führt durch die Reduktion von Ti⁴⁺ Ionen zu Ti³⁺ Ionen zu einer Braunfärbung des Rohlings. Die Braunfärbung kann durch die Temperbehandlung, beispielsweise an Luft oder in Vakuum, bei einer Temperatur im Bereich zwischen 600°C und 1000°C wieder weitgehend eliminiert werden, da die im Glas eingebauten OH-Gruppen für die erneute interne Oxidation von Ti³⁺ zur Verfügung stehen und so das Verhältnis von Ti³⁺/Ti⁴⁺ ≤ 2 x 10⁻⁴ einstellen. Bei dieser Temperbehandlung geht es nicht um die Einwirkung eines Gases auf den Rohling, sondern um die Ausdiffusion von Wasserstoff gemäß Formel (1) als Reaktionsprodukt der erneuten internen Oxidation.

Es hat sich darüber hinaus bewährt, die Konditionierungsbehandlung mit Wasserdampf bei einer Behandlungstemperatur im Bereich von 100°C bis 1100°C, vorzugsweise im Bereich 500°C bis 1000°C, und für eine Dauer von einer (1) Stunde bis 40 Stunden durchzuführen.

Da die Konditionierungsbehandlung bereits bei einer Temperatur von 100°C erfolgen kann, ist eine Oxidation der Ti³⁺ Ionen mit vergleichsweise geringem Energieaufwand möglich. Es ist daher nur der Einsatz konstruktiv wenig aufwändiger Öfen erforderlich und ein mehrmaliges Durchlaufen dieser Behandlungsphase ohne weiteres möglich. Bei Temperaturen unterhalb von etwa 1100°C bleibt die poröse Struktur des Sootkörpers erhalten, so dass sichergestellt ist, dass die gasförmigen Behandlungsreagenzien den Sootkörper durch Diffusion durchdringen und gleichmäßig mit den im Glasnetzwerk verteilten Ti³⁺ Ionen reagieren können. Bei relativ niedriger Temperatur im Bereich zwischen 100°C und 500°C erfordert die Infiltration des Sootkörpers mit Wasserdampf eine entsprechend lange Dauer der Behandlung bis die gewünschte oxidative Reaktion mit den Ti³⁺ Ionen eintritt, wobei sich die Hydroxylgruppen aus dem Wasserdampf an der Oberfläche der einzelnen Sootpartikel anlagern. Je nach Behandlungstemperatur richtet sich die Behandlungsdauer auch nach dem Volumen des Sootkörpers. Eine Mindestbehandlungsdauer von mindestens einer Stunde hat sich als ausreichend bewährt, um eine effektive Infiltration des Sootkörpers mit Wasserdampf zu gewährleisten. Es wird dabei eine im Wesentlichen gleichmäßige Verteilung des Behandlungsgases innerhalb des porösen Sootkörpers erreicht. Der Wasserdampf kann mittels eines inerten Trägergasstroms in den Sootkörper eingebracht werden.

Vorteilhafterweise beträgt der Anteil des Wasserdampfs in Inertgas während der Konditionierungsbehandlung 0,05 bis 50 Vol.-%, vorzugsweise ein bis 20 Vol.-%.

Bei Wasserdampfanteilen unterhalb von 0,05 Vol.-% ergibt sich eine geringe oxidative Wirkung und bei Wasserdampfanteilen oberhalb von 50 Vol.-% kann es zur Bildung von Oberflächenwasser am Sootkörper kommen, das zwar prinzipiell nicht schädlich ist, aber vor dem Verglasen wieder entfernt werden muss.

Es hat sich bewährt nach der Herstellung des TiO₂-SiO₂-Sootkörpers und vor der Fluorierung gemäß Verfahrensschritt (b) eine Trocknung durch zuführen, so dass ein mittlerer OH-Gehalt von weniger als 10 Gew.-ppm eingestellt wird. Mit dieser Dehydratationsbehandlung wird im Sootkörper angelagertes Wasser entfernt, was eine besonders homogene Verteilung des Fluors im nachfolgenden Fluorierungsschritt ermöglicht. Die Trocknung kann rein thermisch unter Inertgas, trockener Luft oder unter Vakuum erfolgen im Temperaturbereich zwischen 700°C bis 1100°C; alternativ ist auch die Anwendung eines Trocknungsreagenz wie etwa Chlor üblich. Der Trocknungs-schritt bewirkt eine Reduzierung des OH-Gehaltes auf weniger als 10 Gew.-ppm. Es folgt dann nach dem Trocknungsschritt die Fluor-Dotierung des TiO₂-SiO₂-Sootkörpers, wobei ein weiterer Trocknungseffekt eintritt. Der OH-Gehalt des Sootkörpers liegt danach bei kleiner 1 Gew.-ppm, was einen in diesem Zustand hohen Anteil an Ti³⁺ Ionen von 20 ppm bis 30 ppm zur Folge hat. Wird ein solcher Sootkörper ohne weitere Behandlung verglast, zeigt der Rohling eine starke Dunkelfärbung.

Fluor hat Einfluss auf die Strukturrelaxation von Kieselglas, so dass für das Ti-dotierte Kieselglas die fiktive Temperatur als Maß für den Ordnungszustand des "eingefrorenen" Glasnetzwerkes gesenkt und der Temperaturbereich mit einem Wärmeausdehnungskoeffizienten von Null erweitert werden kann. Dies ist beispielsweise aus Journal of Applied Physics, Vol. 91 (8), April 2002, S.4886-4890 bekannt. Je nach Behandlungsdauer und Temperatur wird eine Fluorkonzentration zwischen 2.500 Gew.-ppm und 10.000 Gew.-ppm, vorzugsweise zwischen 5.000 Gew.-ppm und 10.000 Gew.-ppm, im Rohling eingestellt.

Eine weitere vorteilhafte Ausgestaltung der Erfindung besteht darin, die FluorBehandlung des TiO₂-SiO₂-Sootkörpers gemäß Verfahrensschritt (b) in einer Fluor enthaltenden Atmosphäre durchzuführen, die vorzugsweise 2 Vol.-% bis 100 Vol.-% SiF₄ enthält. Grundsätzlich kann an Stelle von SiF₄ auch reines Fluor-Gas (F₂) oder SiHF₃ oder SiH₂F₂ eingesetzt werden.

Der Einsatz von Kohlenstoff enthaltenden fluorierenden Gasen wie etwa CHF₃, CF₄, C₂F₆ oder C₃F₈ ist aufgrund ihrer reduzierenden Wirkung eher ungünstig, da dies die Bildung unerwünschter Ti³⁺ Ionen unterstützen würde.

Vorteilhaft ist es zudem, wenn die Fluorierung gemäß Verfahrensschritt (b) in einem Temperaturbereich von 700 °C bis maximal 1000 °C durchgeführt wird. Bei einer Fluorierung in diesem Temperaturbereich ist der poröse Sootkörper gut durchlässig für das Fluor enthaltende Behandlungsgas, so dass ein effektiver Einbau von Fluor in das Glasnetzwerk gewährleistet ist.

Im Sinne eines besonders flachen Verlaufs des Wärmeausdehnungskoeffizienten von Null über einen Temperaturbereich von 20 °C bis 50 °C weist der mit Fluor dotierte TiO₂-SiO₂-Rohling vorteilhafterweise einen mittleren Fluorgehalt im Bereich von 2.500 bis 10.000 Gew.-ppm auf.

Hinsichtlich des Rohlings aus Ti-dotiertem, hochkieselsäurehaltigem Glas wird die oben genannte Aufgabe ausgehend von einem Rohling der eingangs genannten Gattung dadurch gelöst, dass der Rohling gemäß den folgenden Verfahrensschritten (a) Herstellen eines TiO₂-SiO₂-Sootkörpers mittels Flammenhydrolyse von Silizium und Titan enthaltenden Ausgangssubstanzen, (b) Fluorieren des Sootkörpers unter Bildung eines mit Fluor dotierten TiO₂-SiO₂-Sootkörpers, (c) Behandeln des mit Fluor dotierten TiO₂-SiO₂-Sootkörpers in einer Wasserdampf enthaltenden Atmosphäre unter Bildung eines konditionierten Sootkörpers, und (d) Verglasen des konditionierten Sootkörpers unter Bildung des Rohlings aus Titandotiertem, hochkieselsäurehaltigem Glas, hergestellt ist und sich auszeichnet durch einen mittleren Fluorgehalt im Bereich von 2.500 Gew.-ppm bis 10.000 Gew.-ppm, einen mittleren OH-Gehalt im Bereich von 10 Gew.-ppm bis 100 Gew.-ppm, und einen mittleren TiO₂-Gehalt im Bereich von 6 Gew.-% bis 12 Gew.% aus, wobei Titan in den Oxidationsformen Ti³⁺ und Ti⁴⁺ vorliegt und das Verhältnis von Ti³⁺/Ti⁴⁺ auf einen Wert ≤ 2 x 10⁻⁴ eingestellt ist.

Der erfindungsgemäße Rohling zeigt aufgrund seines geringen Anteils an Ti³⁺ Ionen hohe Transparenz von mehr als 60 % im Wellenlängenbereich von 400 nm bis 700 nm für eine Probe mit einer Dicke von 10 mm. Dadurch ist die Inspektion des Rohlings mit üblichen optischen Messverfahren ohne weiteres möglich.

Die Bestimmung der Konzentration von Ti³⁺ kann durch eine Elektronen-Spin-Resonanz-Messung erfolgen, wie sie beispielsweise in der Veröffentlichung von Carson und Mauer in "Optical Attenuation In Titania-Silica Glasses", J. Non-Crystalline Solids, Vol. 11 (1973), S. 368-380 erwähnt wird.

Der Rohling aus Ti-dotiertem Kieselglas weist außerdem eine Dotierung mit Fluor auf. Im Sinne eines besonders flachen Verlaufs des Wärmeausdehnungskoeffizienten von Null über einen Temperaturbereich von 20°C bis 50°C liegt der Fluor-Gehalt im Bereich von 5.000 Gew.-ppm bis 10.000 Gew.-ppm.

Die mittlere Fluor-Konzentration wird üblicherweise nass-chemisch ermittelt. Dabei wird eine Messprobe des erfindungsgemäßen Rohlings zunächst in wässriger NaOH-Lösung aufgelöst. Die F-Konzentration ergibt sich durch Messung der elektromotorischen Kraft der gelösten Messprobe mittels einer Fluor-sensitiven Elektrode.

Der mittlere Hydroxylgruppengehalt (OH-Gehalt) ergibt sich durch Messung der IR-Absorption nach der Methode von D. M. Dodd et al. ("Optical Determinations of OH in Fused Silica", (1966), S. 3911).

Darüber hinaus zeigt der nach dem erfindungsgemäßen Verfahren hergestellte Rohling einen sehr günstigen Verlauf des thermischen Ausdehnungskoeffizienten CTE mit geringer Steigung im Temperaturbereich von 20°C bis 40°C. Die CTE-Steigung, ausgedrückt als Differentialquotient dCTE/dT liegt unter 1,0 ppb/K². Ein derartiger nach dem erfindungsgemäßen Verfahren hergestellter Rohling aus Fluor und Titan-dotiertem Kieselglas zeichnet sich außerdem durch besonders hohe Homogenität der Dotierstoffverteilung aus. Dadurch wird der örtliche Verlauf des CTE über den optisch genutzten Bereich, - auch als "CA-Bereich" (clear aperture) bezeichnet-, optimiert.

Zusätzlich wird beim erfindungsgemäß hergestellten Rohling unterstützt durch die Fluordotierung eine relativ niedrige fiktive Temperatur festgestellt.

Der nach dem erfindungsgemäßen Verfahren hergestellte Rohling ist für den Einsatz in der EUV-Lithographie bestens geeignet. Dies nicht zuletzt da aufgrund seiner Transparenz im sichtbaren Spektralbereich eine optimale Inspektion vor weiteren Verarbeitungsschritten beispielsweise zu einem Spiegelsubstrat möglich ist. Aufgrund der Depotwirkung der durch die Wasserdampfbehandlung eingebauten OH-Gruppen bleibt die Transparenz im sichtbaren Spektralbereich auch nach wiederholten Nachbehandlungsschritten in reduzierender Atmosphäre im Wesentlichen erhalten oder kann nach besonders intensiver reduzierender Nachbehandlung durch eine Temperung im Bereich zwischen 600°C und 1000°C an Luft oder im Vakuum wieder hergestellt oder sogar gegenüber dem Anfangswert übertroffen werden.

### Ausführunasbeispiel

Nachfolgend wird die Erfindung anhand eines Ausführungsbeispiels und einer Zeichnung näher erläutert. In der Zeichnung zeigt jeweils im Vergleich zu einem Material ohne erfindungsgemäße Konditionierungsbehandlung mit Wasserdampf
- **Figur 1**: ein Diagramm über die interne Transmission des nach dem erfindungsgemäßen Verfahren hergestellten Rohlings vor und nach Umformschritten unter reduzierender Atmosphäre, und
- **Figur 2**: ein Diagramm zum Verlauf des CTE über der Temperatur (10°C bis 70°C),

### Beispiel 1

Es wird ein Sootkörper durch Flammenhydrolyse von Octamethylcyclotetrasiloxan (OMCTS) und Titan-Isopropoxid [Ti(OPrⁱ)₄] anhand des bekannten "Outside-Vapor-Deposition-Verfahrens" (OVD-Verfahren) hergestellt. Der Sootkörper besteht aus synthetischem Kieselglas, das mit 8 Gew.-% TiO₂ dotiert ist.

Dieser TiO₂-SiO₂-Sootkörper wird nun einer kombinierten Trocknungs- und Dotier-Behandlung in einer 50 Vol.-% SiF₄ enthaltenden Atmosphäre unterzogen.

Diese Behandlung erfolgt bei einer Temperatur von 900 °C und während einer Dauer von 10 Stunden. Dies führt zu einem festen Einbau von Fluor in den zu verglasenden TiO₂-SiO₂-Sootkörper. Für die nachfolgende Konditionierungsbehandlung unter Wasserdampf-haltiger Atmosphäre mit 2 Vol.-% H₂O bei einer Temperatur von 800 °C wurde eine Behandlungsdauer von 3 Stunden angewendet.

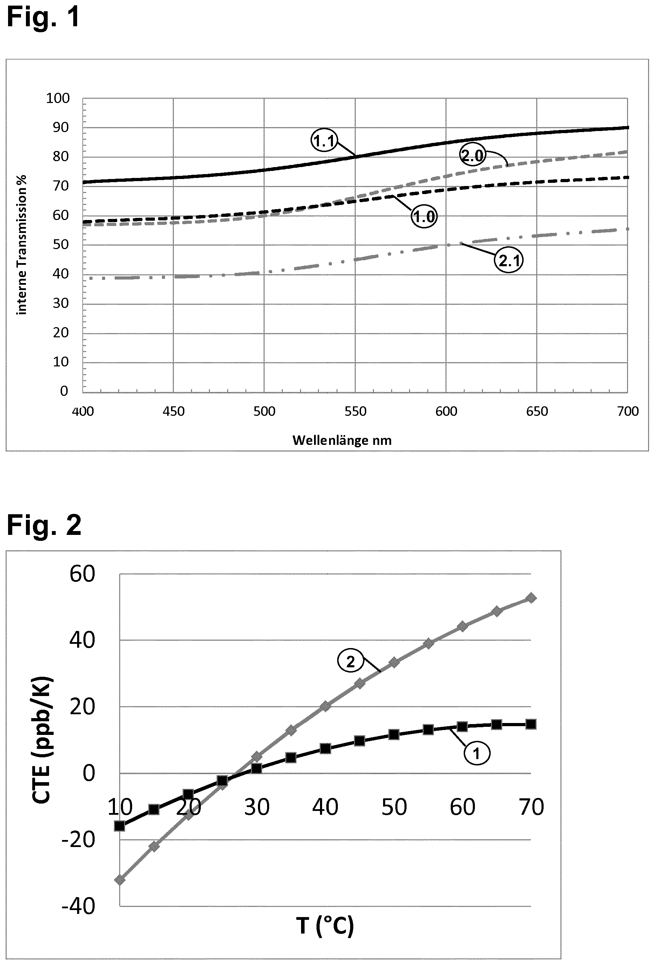

Danach wird der fluorierte und mit Wasserdampf behandelte TiO₂-SiO₂-Sootkörper in einem Sinterofen bei einer Temperatur von ca. 1400 °C unter Helium oder unter Vakuum (bei etwa 10⁻² mbar) für die Dauer von 5 Stunden zu einem transparenten Ti-dotierten Kieselglasrohling in Form einer Stange verglast. Dieser Rohling hat einen sehr geringen Anteil an Ti³⁺ Ionen von nur etwa 6 Gew.-ppm und zeichnet sich durch einen mittleren Fluorgehalt von 6.000 Gew.-ppm sowie durch einen OH-Gehalt von 60 Gew.-ppm aus. Bei einer ersten Messung der internen Transmission im Wellenlängenbereich von 400 nm bis 700 nm an einer Probe mit 10 mm Probendicke (siehe **Figur 1****,** Kurve 1.0) liegen die Werte im Bereich von 60 % bis 70 %.

Der verglaste Rohling wird anschließend durch thermisch mechanische Homogenisierung durch Verdrillen unter Einwirkung einer reduzierenden Knallgasflamme homogenisiert. Dabei nimmt der stangenförmige Rohling eine tonnenartige Form an und zeigt eine leichte Zunahme in der Braunfärbung, die mit einem Transmissionswert im sichtbaren Spektralbereich (Probendicke 10 mm) von etwa 50 % einhergeht.

Es folgt ein weiterer Umformprozess zu einem zylindrischen Formkörper. Dabei wird der Rohling in eine Schmelzform aus Graphit gestellt, die einen Boden mit rundem oder polygonem Querschnitt und Außenabmessungen von etwa 300 mm aufweist. Zum Verformen wird die gesamte Schmelzform mit dem darin befindlichen Rohling zunächst auf 1250 °C und anschließend mit einer Rampe 9 °C/min auf 1600 °C aufgeheizt und danach mit einer Rampe von 2 °C/min auf eine Temperatur von 1680 °C. Bei dieser Temperatur wird die Kieselglasmasse so lange gehalten, bis das erweichte Ti-dotierte Kieselglas unter Wirkung seines eigenen Gewichts in den Boden der Schmelzform ausgeflossen ist und diese dabei aufgefüllt hat. Aus dem Rohling wird so eine runde oder polygone Platte mit einer Dicke von etwa 60 mm geformt, die in allen drei Betrachtungsrichtungen schichten- und schlierenfrei ist. Nach den Umformschritten in reduzierender Atmosphäre wird im Rohling ein Anteil von 9 Gew.-ppm Ti³⁺ bzw. ein Verhältnis von Ti³⁺ / Ti⁴⁺ von etwa 2,5 x 10⁻⁴ festgestellt. Die interne Transmission im sichtbaren Spektralbereich an einer 10 mm dicken Probe dieses Rohlings liegt im Bereich zwischen etwa 40 bis 50 %.

Zum Abbau mechanischer Spannungen und zur Verminderung der Doppelbrechung wird der Ti-dotierte Kieselglas-Rohling einer Temperbehandlung unterzogen, bei der der zylindrische Rohling während einer Haltezeit von 8 Stunden unter Luft und Atmosphärendruck auf 950 °C erhitzt und anschließend mit einer Abkühlrate von 1 °C/h auf eine Temperatur von 700 °C abgekühlt und bei dieser Temperatur 4 Stunden lang gehalten wird. Danach folgt eine Abkühlung auf 300°C mit einer höheren Abkühlrate von 50 °C/h, woraufhin der Ofen abgestellt und der Rohling der freien Abkühlung des Ofens überlassen wird. Nach dieser Temperbehandlung stellt sich eine mittlere fiktive Temperatur (T_{f}) von 800°C ein.

Ein gängiges Messverfahren zur Ermittlung der fiktiven Temperatur anhand einer Messung der Raman-Streuintensität bei einer Wellenzahl von etwa 606 cm⁻¹ ist in "Ch. Pfleiderer et. al.; The UV-induced 210 nm absorption band in fused silica with different thermal history and stoichiometry; Journal of Non-Cryst. Solids 159 (1993), S. 143-145" beschrieben.

Durch die Temperbehandlung an Luft wird die Depotwirkung der durch die Konditionierungsbehandlung mit Wasserdampf eingebauten OH-Gruppen aktiviert, so dass der Rohling sogar wieder heller erscheint als anfänglich nach der Verglasung. Gemäß **Figur 1****,** Kurve 1.1 liegt die interne Transmission des erfindungsgemäß hergestellten Rohlings im Mittel bei 80%.

Unter interner Transmission wird die Transmission über die Probendicke korrigiert um den Anteil der Oberflächenverluste bezeichnet.

Für den nach dem erfindungsgemäßen Verfahren hergestellten Rohling wird außerdem der mittlere thermische Ausdehnungskoeffizient interferometrisch anhand der Methode ermittelt, wie sie beschrieben ist in: "R. Schödel, Ultra-high accuracy thermal expansion measurements with PTB's precision interferometer" Meas. Sci. Technol. 19 (2008) 084003 (11 pp)".

Beim erfindungsgemäß hergestellten Rohling wird eine Nulldurchgangstemperatur (T_{ZC}) von 28°C und eine Steigung des CTE von 0,8 ppb/K² festgestellt.

Da der Rohling in seinen Randbereichen eine relativ starke Spannungsdoppelbrechung aufweist, wird von den Stirnflächen ein Teil des Übermaßes gegenüber der Bauteil-Kontur abgenommen, nämlich eine Dicke von 3 mm. Der Rohling zeichnet sich aufgrund eines Verhältnisses Ti³⁺/Ti⁴⁺ von 0,7 x 10⁻⁴ durch hohe Transparenz im sichtbaren Spektralbereich aus und kann nun mit den üblichen optischen Messverfahren inspiziert und entsprechend den resultierenden Messergebnissen weiteren Verarbeitungsschritten zugeführt werden.

Das Diagramm von **Figur 2** zeigt den thermischen Ausdehnungskoeffizienten CTE als Funktion der Temperatur. Aus Kurve 1 ist ein besonders flacher Verlauf des CTE für den nach dem erfindungsgemäßen Verfahren hergestellten, fluordotierten TiO₂-SiO₂-Rohling ersichtlich. Die Steigung des CTE beträgt 0,8 ppb/K² bei einer Nulldurchgangstemperatur von 28°C.

### Vergleichsbeispiel 1

Unter den Bedingungen wie in Beispiel 1 näher erläutert, wird ein TiO₂-SiO₂-Sootkörper hergestellt und einer kombinierten Trocknungs- und Dotier-Behandlung in einer 20 Vol.-% SiF₄ enthaltenden Atmosphäre unterzogen.

Diese Behandlung erfolgt bei einer Temperatur von 900 °C und während einer Dauer von 10 Stunden und führt zu einem festen Einbau von Fluor in den zu verglasenden TiO₂-SiO₂-Sootkörper. Es schließt sich nun eine Sauerstoffbehandlung an, bei der für vier Stunden bei 1000°C eine Atmosphäre von 100% Sauerstoff unter Normaldruck auf den Sootkörper einwirkt. Danach folgt die Verglasung bei 1550°C unter Helium-Atmosphäre. Der so erhaltene Rohling weist einen OH-Gehalt kleiner 1 Gew.-ppm auf (unterhalb der Nachweisgrenze), zeigt aber aufgrund des günstigen Verhältnisses von Ti³⁺ zu Ti⁴⁺ von 2 x 10⁻⁴ zunächst noch gute Transmissionswerte zwischen etwa 60 % und 75 % im sichtbaren Spektralbereich, wie in **Figur 1****,** Kurve 2.0 zeigt. Dieser Rohling muss nun homogenisiert und umgeformt werden. Diese nachfolgenden Verfahrensschritte werden unter reduzierender Atmosphäre durchgeführt. Schon nach dem Homogenisieren ist eine deutliche Braunfärbung des Rohlings festzustellen, die sich noch beim anschließenden Umformen verstärkt. Eine Temperbehandlung bei 1000°C unter Luft ändert an dieser Braunfärbung nichts. Durch die reduzierende Atmosphäre während des Homogenisierens und Umformens wird das Verhältnis Ti³⁺ /Ti⁴⁺ zugunsten von Ti³⁺ Ionen verschoben und liegt dann bei etwa 2,5 x 10⁻⁴. Dementsprechend zeigt ein 10 mm dickes Probenstück dieses Rohlings einen irreversiblen Rückgang der internen Transmission auf Werte um 45 %, wie aus **Figur 1****,** Kurve 2.1 ersichtlich. Diese Eigenschaft kann durch die Temperbehandlung an Luft nicht verbessert werden, da praktisch kein Sauerstoff mehr in den verglasten Rohling in realistischer Zeit eindringen kann, um dort für eine erneute Oxidation von Ti³⁺ in Ti⁴⁺ zur Verfügung zu stehen. Das nach dem Vergleichsbeispiel hergestellte Vergleichsmaterial V1 ist damit zur weiteren Qualifizierung für den Einsatz in der EUV-Lithographie ungeeignet. Somit bewirkt die Sauerstoffbehandlung vor dem Verglasen im Gegensatz zum erfindungsgemäßen Verfahren mit einer Konditionierungsbehandlung mit Wasserdampf keinen Einbau von Sauerstoff im Sinne einer Depotwirkung.

Hinsichtlich des Verlaufs des thermischen Ausdehnungskoeffizienten CTE als Funktion der Temperatur zeigt sich in **Figur 2** für das Vergleichsmaterial V1 keine Änderung zu Kurve 1 von Beispiel 1, da der Verlauf des CTE im Wesentlichen vom Titan- und vom Fluorgehalt bestimmt wird, der im Vergleichsbeispiel 1 und im erfindungsgemäßen Beispiel 1 gleich ist.

### Vergleichsbeispiel 2

Unter den Bedingungen wie in Beispiel 1 näher erläutert, wird ein TiO₂-SiO₂-Sootkörper hergestellt, der jedoch nur einen TiO₂ Gehalt von 7,4 Gew.-% aufweist. Der TiO₂-SiO₂-Sootkörper wird ohne einen Trocknungsschritt und ohne eine Fluorbehandlung verglast. Es wird auch auf eine Konditionierungsbehandlung mit Wasserdampf oder mit Sauerstoff verzichtet. Der Rohling enthält nach dem Verglasen einen OH-Gehalt von 250 Gew.-ppm. Dieser recht hohe OH-Gehalt führt zu relativ hohen Transmissionswerten von 65 % vor dem Umformen und von sogar 85 % nach Umformen und Tempern mit entsprechend kleinen Verhältnis Ti³⁺/Ti⁴⁺. Die Werte für die interne Transmission sind jedoch allein nicht ausschlaggebend für die Eignung in der EUV-Lithographie, vielmehr muss auch der CTE-Verlauf und die fiktive Temperatur betrachtet werden.

Der Verlauf des CTE wird nach Homogenisieren, Umformen und Tempern, wie in Beispiel 1 beschrieben, ermittelt. In **Figur 2** zeigt Kurve 2 für dieses Vergleichsmaterial V2 einen sehr steilen Verlauf des CTE über der Temperatur. Die Steigung des CTE beträgt in diesem Fall 1,6 ppb/K² bei einer Nulldurchgangstemperatur von 28°C. Die fiktive Temperatur (T_{f}) liegt aufgrund des Fehlens von Fluor bei 930°C.

Nachfolgend werden die wesentlichen Eigenschaften des nach dem erfindungsgemäßen Verfahren hergestellten Rohlings nach Beispiel 1 im Vergleich zu dem Vergleichsmaterial V1 und V2 aus den Vergleichsbeispielen 1 und 2 tabellarisch zusammengefasst.

**Tabelle 1**

| ***Eigenschaften*** | Rohling aus erfindungsgemäßem Verfahren | Vergleichsmaterial V1 | Vergleichsmaterial V2 |
|---|---|---|---|
| Titanoxid-Gehalt [Gew.-%] | 8,0 | 8,0 | 7,4 |
| Fluor-Gehalt [Gew.-ppm] | 6.000 | 6.000 | 0 |
| Konditionierungsbehandlung | Wasserdampf | Sauerstoff | - |
| OH-Gehalt [Gew.-ppm] | 60 | < 1 | 250 |
| Fiktive Temperatur [°C] | 800 | 800 | 930 |
| Int. Transmission vor Umformen [%] | ∼ 60 | ∼ 60 | ∼ 65 |
| Ti³⁺/Ti⁴⁺ vor Umformen [10⁻⁴] | 1,7 | 1,7 | 1,4 |
| Int. Transmission nach Umformen und Tempern [%] | ∼ 80 | ∼ 45 | ∼ 85 |
| Ti³⁺/Ti⁴⁺ nach Umformen und Tempern [10⁻⁴] | < 0,7 | 2,5 | 0,5 |
| ΔCTE/ΔT [ppb/K²] | 0,8 | 0,8 | 1,6 |
| Eignung für Einsatz in EUV-Lithographie | sehr gut | mäßig bis schlecht | schlecht |

## Patentansprüche

1. Verfahren zur Herstellung eines Rohlings aus Titan-dotiertem, hochkieselsäurehaltigem Glas mit einer internen Transmission von mindestens 60 % im Wellenlängenbereich von 400 nm bis 700 nm bei einer Probendicke von 10 mm, wobei das Titan in den Oxidationsformen Ti³⁺ und Ti⁴⁺ vorliegt, und mit einem vorgegebenen Fluorgehalt für den Einsatz in der EUV-Lithographie, umfassend die folgenden Verfahrensschritte :
(a) Herstellen eines TiO₂-SiO₂-Sootkörpers mittels Flammenhydrolyse von Silizium und Titan enthaltenden Ausgangssubstanzen,
(b) Fluorieren des Sootkörpers unter Bildung eines mit Fluor dotierten TiO₂-SiO₂-Sootkörpers,
(c) Behandeln des mit Fluor dotierten TiO₂-SiO₂-Sootkörpers in einer Wasserdampf enthaltenden Atmosphäre unter Bildung eines konditionierten Sootkörpers,
(d) Verglasen des konditionierten Sootkörpers unter Bildung eines Rohlings aus Titan-dotiertem, hochkieselsäurehaltigem Glas mit einem mittleren OH-Gehalt im Bereich von 10 Gew.-ppm bis 100 Gew.-ppm und mit einem mittleren Fluorgehalt im Bereich von 2.500 bis 10.000 Gew.-ppm.

2. Verfahren nach Anspruch 1 **dadurch gekennzeichnet, dass** der Rohling nach dem Verglasen einer Behandlung in reduzierender Atmosphäre unterzogen wird, bei der sich das Verhältnis Ti³⁺ / Ti⁴⁺ vergrößert unter Reduzierung der internen Transmission im Wellenlängenbereich 400 nm bis 700 nm und wobei anschließend der Rohling einer Temperbehandlung bei einer Temperatur im Bereich zwischen 600°C und 1000°C unterzogen wird, um die Reduzierung der internen Transmission rückgängig zu machen.

3. Verfahren nach Anspruch 1 oder 2, **dadurch gekennzeichnet, dass** die Konditionierungsbehandlung mit Wasserdampf gemäß Verfahrensschritt (c) bei einer Behandlungstemperatur im Bereich von 100°C bis 1100 °C, vorzugsweise im Bereich 500°C bis 1000 °C, und für eine Dauer von 1 bis 10 Stunden durchgeführt wird.

4. Verfahren nach einem der vorhergehenden Ansprüche, **dadurch gekennzeichnet, dass** bei der Konditionierungsbehandlung mit Wasserdampf gemäß Verfahrensschritt (c) der Anteil des Wasserdampfes in Inertgas zwischen 0,05 Vol.-% und 50 Vol.-%, vorzugsweise zwischen 1 und 20 Vol.-% beträgt.

5. Verfahren nach einem der vorhergehenden Ansprüche, **dadurch gekennzeichnet, dass** vor dem Fluorieren gemäß Verfahrensschritt (b) eine Trocknung durchgeführt wird, so dass ein mittlerer OH-Gehalt von weniger als 10 Gew.-ppm eingestellt wird.

6. Verfahren nach einem der vorhergehenden Ansprüche, **dadurch gekennzeichnet, dass** das Fluorieren gemäß Verfahrensschritt (b) in einer Fluor enthaltende Atmosphäre durchgeführt wird, die 2 Vol.-% bis 100 Vol.-% SiF₄ enthält.

7. Verfahren nach einem der vorhergehenden Ansprüche, **dadurch gekennzeichnet, dass** die Fluorierung gemäß Verfahrensschritt (b) in einem Temperaturbereich von 700 °C bis maximal 1000 °C durchgeführt wird.

8. Rohling aus Titan-dotiertem, hochkieselsäurehaltigem Glas für den Einsatz in der EUV-Lithographie, mit einer internen Transmission von mindestens 60 % im Wellenlängenbereich von 400 nm bis 700 nm bei einer Probendicke von 10 mm, hergestellt gemäß den folgenden Verfahrensschritten:
(a) Herstellen eines TiO₂-SiO₂-Sootkörpers mittels Flammenhydrolyse von Silizium und Titan enthaltenden Ausgangssubstanzen
(b) Fluorieren des Sootkörpers unter Bildung eines mit Fluor dotierten TiO₂-SiO₂-Sootkörpers,
(c) Behandeln des mit Fluor dotierten TiO₂-SiO₂-Sootkörpers in einer Wasserdampf enthaltenden Atmosphäre unter Bildung eines konditionierten Sootkörpers, und
(d) Verglasen des konditionierten Sootkörpers unter Bildung des Rohlings aus Titan-dotiertem, hochkieselsäurehaltigem Glas,
mit einem mittleren Fluorgehalt im Bereich von 2.500 Gew.-ppm bis 10.000 Gew.-ppm, mit einem mittleren OH-Gehalt im Bereich von 10 Gew.-ppm bis 100 Gew.-ppm, und mit einem mittlerenTiO₂-Gehalt im Bereich von 6 Gew.-% bis 12 Gew.%, wobei Titan in den Oxidationsformen Ti³⁺ und Ti⁴⁺ vorliegt und das Verhältnis von Ti³⁺/Ti⁴⁺ auf einen Wert ≤ 2 x 10-⁴ eingestellt ist.

## Claims

1. A method for producing a blank of titanium-doped glass with a high silicic acid content, an internal transmission of at least 60% in a wavelength range of 400 nm to 700 nm at a sample thickness of 10 mm, the titanium being present in oxidation forms Ti³⁺ and Ti⁴⁺, and with a given fluorine content for use in EUV lithography, the method comprising the steps of:
(a) producing a TiO₂-SiO₂ soot body by flame hydrolysis of silicon- and titanium-containing precursor substances,
(b) fluorinating the TiO₂-SiO₂ soot body so as to form a fluorine-doped TiO₂-SiO₂ soot body,
(c) treating the fluorine-doped TiO₂-SiO₂ soot body in a water vapor-containing atmosphere so as to form a conditioned soot body,
(d) vitrifying the conditioned soot body so as to form a blank of titanium-doped glass having a high silicic-acid content, a mean OH content in the range of 10 wt. ppm to 100 wt. ppm and a mean fluorine content in the range of 2,500 to 10,000 wt. ppm.

2. The method according to claim 1, **characterized in that** the blank after vitrifying is subjected to a treatment in a reducing atmosphere in which the ratio of Ti³⁺ / Ti⁴⁺ is increased, while the internal transmission in the wavelength range 400 nm to 700 nm is reduced, and wherein subsequently the blank is subjected to an annealing treatment at a temperature in the range between 600° C and 1000° C to undo the reduction of the internal transmission.

3. The method according to claim 1 or 2, **characterized in that** the conditioning treatment in a water vapor-containing atmosphere according to method step (c) is carried out at a treatment temperature in the range of 100° C to 1000° C, preferably in the range of 500°C to 1000°C, and for a duration of 1 to 10 hours.

4. The method according to any one of the preceding claims, **characterized in that** in the conditioning treatment in a water vapor-containing atmosphere according to method step (c) the amount of the water vapor in an inert gas is between 0.05% by vol. and 50% by vol., preferably between 1 and 20% by vol..

5. The method according to any one of the preceding claims, **characterized in that** prior to fluorinating according to method step (b), drying is performed to set the mean OH content to less than 10 wt. ppm.

6. The method according to any one of the preceding claims, **characterized in that** fluorinating according to method step (b) is performed in a fluorine-containing atmosphere containing 2% by vol. to 100% by vol. of SiF₄.,.

7. The method according to any one of the preceding claims, **characterized in that** fluorinating according to method step (b) is performed in a temperature range of 700° C to not more than 1000° C.

8. A blank consisting of titanium-doped glass with a high silicic-acid content for use in EUV lithography, with an internal transmission of at least 60% in the wavelength range of 400 nm to 700 nm at a sample thickness of 10 mm, produced according to the following method steps:
(a) producing a TiO₂-SiO₂ soot body by flame hydrolysis of silicon- and titanium-containing precursor substances,
(b) fluorinating the soot body so as to form a fluorine-doped TiO₂-SiO₂ soot body,
(c) treating the fluorine-doped TiO₂-SiO₂ soot body in a water vapor-containing atmosphere so as to form a conditioned soot body, and
(d) vitrifying the conditioned soot body so as to form the blank of titanium-doped glass with a high silicic-acid content,
with a mean fluorine content in the range of 2,500 wt. ppm to 10,000 wt. ppm, with a mean OH content in the range of 10 wt. ppm to 100 wt. ppm, and with a mean TiO₂ content in the range of 6% by wt. to 12% by wt., wherein titanium is present in the oxidation forms Ti³⁺ and Ti⁴⁺, and the ratio of Ti³⁺/Ti⁴⁺ is adjusted to a value of ≤ 2 x 10⁻⁴.

## Revendications

1. Procédé de fabrication d'une ébauche en verre dopé au titane, à haute teneur en acide silicique, ayant une transmission interne d'au moins 60% dans la plage de longueurs d'onde de 400 nm à 700 nm avec une épaisseur d'échantillon de 10 mm, le titane étant présent dans les formes d'oxydation Ti³⁺ et Ti⁴⁺, et ayant une teneur en fluor prédéfinie pour l'utilisation en lithographie EUV, comprenant les étapes de procédé suivantes :
(a) fabrication d'un corps de suie TiO₂-SiO₂ par hydrolyse à la flamme de substances de départ contenant du silicium et du titane,
(b) fluoration du corps de suie avec formation d'un corps de suie TiO₂-SiO₂ dopé avec du fluor,
(c) traitement du corps de suie TiO₂-SiO₂ dopé avec du fluor dans une atmosphère contenant de la vapeur d'eau, avec formation d'un corps de suie conditionné,
(d) vitrification du corps de suie conditionné, avec formation d'une ébauche en verre dopé au titane, à haute teneur en acide silicique, ayant une teneur en OH moyenne comprise dans la plage de 10 ppm en poids à 100 ppm en poids et ayant une teneur en fluor moyenne comprise dans la plage de 2 500 à 10 000 ppm en poids.

2. Procédé selon la revendication 1, **caractérisé en ce que** l'ébauche, après la vitrification, est soumise à un traitement en atmosphère réduite, dans laquelle le rapport Ti³⁺ / Ti⁴⁺ augmente avec réduction de la transmission interne dans la plage de longueurs d'onde de 400 nm à 700 nm, et l'ébauche étant ensuite soumise à un traitement thermique à une température située dans la plage comprise entre 600°C et 1000°C afin d'annuler la réduction de la transmission interne.

3. Procédé selon la revendication 1 ou 2, **caractérisé en ce que** le traitement de conditionnement est réalisé avec de la vapeur d'eau selon l'étape de procédé (c) à une température de traitement située dans la plage de 100°C à 1100°C, de préférence dans la plage de 500°C à 1000°C, et pour une durée de 1 à 10 heures.

4. Procédé selon l'une quelconque des revendications précédentes, **caractérisé en ce que** lors du traitement de conditionnement avec de la vapeur d'eau selon l'étape de procédé (c), la proportion de la vapeur d'eau en gaz inerte est comprise entre 0,05% en volume et 50% en volume, de préférence entre 1 et 20% en volume.

5. Procédé selon l'une quelconque des revendications précédentes, **caractérisé en ce qu'**avant la fluoration selon l'étape de procédé (b), un séchage est réalisé de sorte qu'une teneur en OH moyenne de moins de 10 ppm en poids est ajustée.

6. Procédé selon l'une quelconque des revendications précédentes, **caractérisé en ce que** la fluoration selon l'étape de procédé (b) est réalisée dans une atmosphère contenant du fluor, laquelle contient 2% en volume à 100% en volume de SiF₄.

7. Procédé selon l'une quelconque des revendications précédentes, **caractérisé en ce que** la fluoration selon l'étape de procédé (b) est réalisée dans une plage de température de 700° C à maximum 1000°C.

8. Ébauche en verre dopé au titane, à haute teneur en acide silicique, pour l'utilisation en lithographie EUV, ayant une transmission interne d'au moins 60% dans la plage de longueurs d'onde de 400 nm à 700 nm avec une épaisseur d'échantillon de 10 mm, fabriquée selon les étapes de procédé suivantes :
(a) fabrication d'un corps de suie TiO₂-SiO₂ par hydrolyse à la flamme de substances de départ contenant du silicium et du titane,
(b) fluoration du corps de suie avec formation d'un corps de suie TiO₂-SiO₂ dopé avec du fluor,
(c) traitement du corps de suie TiO₂-SiO₂ dopé avec du fluor dans une atmosphère contenant de la vapeur d'eau, avec formation d'un corps de suie conditionné, et
(d) vitrification du corps de suie conditionné avec formation d'une ébauche en verre dopé au titane, à haute teneur en acide silicique,
ayant une teneur en fluor moyenne comprise dans la plage de 2 500 ppm en poids à 10 000 ppm en poids, ayant une teneur en OH moyenne comprise dans la plage de 10 ppm en poids à 100 ppm en poids, et ayant une teneur en TiO₂ moyenne située dans la plage de 6% en poids à 12% en poids, le titane étant présent dans les formes d'oxydation Ti³⁺ et Ti⁴⁺, et le rapport Ti³⁺ / Ti⁴⁺ étant ajustée sur une valeur ≤ 2 x 10⁴.
